# EUROPEAN PATENT SPECIFICATION

(11) **EP 3 003 854 B1**
(45) Date of publication and mention of the grant of the patent: **19.10.2022**
(21) Application number: 14804753.3
(22) Date of filing: 19.03.2014
(51) Int. Cl.: B64C 1/14, B64D 37/04, B64D 37/32, E06B 7/23, F16J 15/06, H05K 9/00

(54) **IMPROVED FUEL TANK ACCESS DOOR GASKET WITH REINFORCED SEAL**
VERBESSERTE DICHTUNG EINER KRAFTSTOFFTANKZUGANGSTÜR MIT VERSTÄRKTER ABDICHTUNG
JOINT AMÉLIORÉ DE PORTE D'ACCÈS DE RÉSERVOIR DE CARBURANT AYANT UN JOINT RENFORCÉ

(30) Priority: 31.05.2013 US 201361829711 P; 22.11.2013 US 201361907788 P
(43) Date of publication of application: 13.04.2016
(73) Proprietor: Parker-Hannifin Corporation, Cleveland, OH 44124-4141 (US)
(72) Inventor: COPPOLA, Stephen, J., Boston, MA 02127 (US); VOZZELLA, Anthony, Winchester, MA 01890 (US); PARENTEAU, Nick, Somerville, MA 02145 (US); SPIES, George, Wakefield, MA 01880 (US); BROWN, Gerard, Melrose, MA 02176 (US); HALLORAN, Scott, Tewksbury, MA 01876 (US); BYTHROW, Steven, Quincy, MA 02169 (US)
(74) Representative: Davies, Gregory Mark
(86) International application number: PCT/US2014/031161
(87) International publication number: WO 2014/193520

(56) References cited:
- WO-A2-99/22556
- US-A- 3 019 281
- US-A- 3 531 133
- US-A- 4 530 443
- US-A- 4 579 248
- US-A- 4 579 248
- US-A- 5 215 314
- US-A- 5 366 664
- US-A- 5 366 664
- US-A- 5 700 017
- US-B1- 6 536 775
- US-B1- 6 598 883
- US-B1- 6 598 883
- US-B2- 6 761 360
- US-B2- 6 761 360

## Description

### BACKGROUND OF THE INVENTION

The scope of the invention is defined by the independent claims 1 and 5. The present invention relates to a gasket assembly for use in sealing and EMI shielding applications, particularly for aircraft related applications, and more particularly for sealing and protecting aircraft fuel tank access doors and panels. The gasket assembly to which the invention relates, includes the following components: (1) an improved seal design; (2) a molded grommet design; (3) an improved reinforced elastomeric sealing element; and (4) a conductive triple stranded knitted wire mesh.

The present invention relates to an annular elastomeric gasket having a conductive mesh integrated into the gasket to provide electrical conductivity between adjacent aircraft surfaces to be sealed. The gaskets of the invention are designed to prevent failure under the dynamic load conditions experienced by the aircraft wing assembly during flight. This design provides a void space for the volumetric expansion of the sealing member under the compressive loading experienced during flight, thereby preventing leakage from the seal.

In addition to the foregoing, the gaskets of the invention may contain additional features designed to improve the sealing effectiveness, survivability, and overall performance of the gasket as explained in more detail herein.

Gaskets are typically used in EMI shielding applications where flexibility in addition to shielding effectiveness is required due to the particular application. Composite gaskets generally comprising a metal core material enclosed or encapsulated within a resilient polymeric material are known in the art. Such gaskets have sufficient structural integrity to be useful in sealing components in corrosive and high performance environments, such as for aircraft. Examples of such gaskets are disclosed in U.S. Patent No. 2,477,267 and U.S. Patent No. 3,126,440.

U.S. Patent No. 4,900,877 discloses a gasket for EMI shielding and environmental sealing. The gasket of this patent has a metallic electrically conductive deformable element adapted to be positioned in a gap between adjacent conductive surfaces. The gap is filled with a gel for sealing the space between the surfaces and for encapsulating the metallic structure to provide environmental protection against moisture and corrosion.

The gaskets described in the aforementioned patents may not be acceptable for high performance applications, typically aircraft applications, where a variety of performance characteristics may be required in harsh working environments. For example, in addition to EMI shielding and sealing, electrical bonding of components and protection against corrosive environments may be a necessity.

Additional problems are created when gaskets are used in external aircraft applications, such as for sealing aircraft fuel tanks. For example, during assembly of the fuel tank access panel, tightening of the bolts used in the panel can rupture the gasket, allowing fluids to leak from the sealing area and adjacent metal surfaces to come into direct contact with each other. Failure can also occur as a result of the dynamic loads placed on the aircraft wing surfaces during flight. This can also cause the gasket to be compressed beyond its normal tolerances, resulting in the separation of the reinforcing mesh from the elastomer.

Various attempts have been made to solve problems associated with aircraft fuel access ports and panels. For instance, U.S. Patent 4,579,248 describes an improved gasket for sealing aircraft fuel tanks. The gaskets of the reference incorporate outwardly extending seal members fabricated from a fluorosilicate rubber to provide the gasket with improved corrosion resistance and fluid retention. As shown in the reference however, the outwardly extending gasket end portion does not contact either of the opposed aircraft fuel tank surfaces upon compression of the gasket. U.S. Patent 7,900,412 is directed to polysulfide sealing materials containing fiberglass reinforcing materials which can be applied to aircraft fuel tank access ports as caulking materials. While the above references provide solutions to some of the problems associated with fuel tank panel sealing, the use of caulking materials such as polysulfide, in particular, usually requires significant downtime due to the curing time required for the polysulfide. This is a result of the time required for the application and curing of the polysulfide caulk. Additionally, when a gasket is replaced, the old caulk must first be removed, and the removal procedure can result in damage to the equipment. Furthermore, most caulking compounds have a limited shelf life which can create inventory obsolescence and increase associated costs.

It will be readily appreciated that it would be advantageous to develop an improved gasket for sealing aircraft fuel tank access panels and doors which overcomes the problems associated with the techniques and materials currently in use, which would be able to provide environmental sealing between mating surfaces, and which contains such additional features as may be useful to optimize the performance of the gasket.

US4579248 discloses in figure 4 a gasket that is made up of a main central portion that is a wire mesh fabric (102), an inner edge seal portion (104) connected to an inner edge of the wire mesh fabric, and an outer edge seal portion (106) connected to an outer edge of the wire mesh fabric. The inner and outer edge seal portions (104, 106) are formed with a material such as fluorosilicone synthetic rubber and are intended to be in sealing engagement between surface portions of a fuel tank access panel, while the central wire mesh fabric (102) is impregnated with a grease-like lubricant and intended to be in metal to metal contact to provide electrical conductivity between surface portions of a fuel tank access panel.

### SUMMARY OF THE INVENTION

The present invention is directed generally to improved gaskets for sealing and protecting aircraft fuel tank access doors and panels. The improvement of the invention results in more effective sealing and protection of aircraft wing-mounted fuel tanks, access doors and panels. The improvement comprises the use of a gasket having a flexible design for withstanding the dynamic stresses and forces associated with aircraft wings during flight, and results in greater sealing and environmental protection of the fuel tank and aircraft.

The gasket of the invention is defined in appended independent claims 1 and 5. The gasket comprises an EMI shielding gasket for aircraft fuel tank access doors and panels. The gasket, which can be circular, oval, rectangular, square, or any other shape designed to fit the access door configuration, has an annular configuration with a hollow core section, such as a ring gasket. The gasket further comprises an elastomeric sheet having embedded therein an electrically conductive mesh for establishing electrical conductivity between adjacent metallic surfaces, and particularly adjacent aircraft wing mounted fuel tank and access door surfaces. The aircraft surfaces are typically aluminum or titanium surfaces.

In one aspect, the electrically conductive mesh is a metallic mesh formed from metal wire or fiber. Suitable metals include, for example, copper, nickel, silver, aluminum, bronze, steel, tin, or an alloy or combination thereof. Electrically conductive fibers can also be non-conductive fibers having an electrically-conductive coating, metal wires, carbon fibers, graphite fibers, inherently-conductive polymer fibers, or a combination thereof. Preferably, the mesh is a metallic mesh formed from triple strand wire.

In another aspect, a grommet is affixed to the inner annular region of the gasket, forming a border between the gasket and the hollow annular space. The grommet is designed to encapsulate the innermost end section of the gasket, effectively forming a border between the inner annular region of the gasket and the void of the annular space. The grommet can be formed from a metal or a molded plastic.

The elastomeric material can, in general, be any of a variety of natural or synthetic rubbers, such as EPDM, nitrile rubber, silicone, urethane, polysulfide, polytetrafluoroethylene, butadiene, neoprene, and the like. Preferably, the elastomeric material is a fluorosilicone polymer reinforced with Kevlar fibers.

In one embodiment, the gasket is divided into three zones or regions extending outwardly from the assumed center of the gasket to the end portion of the gasket: an inner region, a central region, and an outer region, all of said regions being contiguous and part of a unitary gasket structure. The inner and outer regions have the same thickness.

The central region has an intermediate zone positioned between two peripheral zones. The peripheral zones are thinner than the inner and outer regions of the gasket, while the intermediate zone, which is positioned between the peripheral zones, has a thickness greater than the thickness of the inner and outer regions. Preferably, the intermediate zone is tubular in configuration. The gasket can optionally include a rubberized tip portion extending outwardly from the edge or rim of the outer region.

In another embodiment, the gasket comprises, as a single unitary structure, an inner region and an outer region, wherein the inner region and outer region are contiguous, and further wherein the inner region is thicker than the outer region. The outer region has affixed to its outwardly extending end portion a rubberized tip portion. Preferably, the rubberized tip portion has a bulb or tubular shape, and is thicker in dimension than the inner region of the gasket. Upon compression of the gasket as a result of the installation and securing of the aircraft fuel tank access door, the rubberized tip portion, which extends beyond the lateral surface of the access door, is compressed, thereby sealing the interior section of the gasket.

A further embodiment of the invention comprises an assembly including a gasket embodiment as described above, the aircraft fuel tank outer surface access port, and the aircraft fuel tank sealing panel or door. The aircraft surfaces are generally fabricated from aluminum or titanium. The gasket is inserted into the space between the access port and sealing panel, a series of bolts is inserted between the panel, the gasket and the access port, and the bolts are tightened to compress the gasket and seal the port. The shape of the gasket is designed to conform to the shape of the access port, and will typically comprise an annular shape with a series of radial holes for accommodating the sealing bolts.

The foregoing aspects and embodiments of the invention are intended to be illustrative only, and are not meant to restrict the scope of the invention as defined by the appended claims.

### BRIEF DESCRIPTION OF THE DRAWINGS

The foregoing and other advantages and features of the invention will become apparent upon reading the following detailed description with reference to the accompanying drawings in which:
FIG. 1 is a cross-sectional view of one embodiment of the gasket design of the invention.
FIG. 2 is a cross-sectional view of another embodiment of the gasket design of the invention.
FIG. 3 is a perspective view of the gasket of FIG. 1.
FIG. 4 is a perspective view of the gasket of the invention depicting a circular grommet positioned on the innermost surface of the gasket, encapsulating the end section thereof.

### DETAILED DESCRIPTION OF THE INVENTION

The gasket of the present invention is primarily intended to be used for sealing and EMI shielding of aircraft fuel tank access doors and panels to the fuel tank access port which receives the fuel for the aircraft. These access doors and panels are typically mounted on the wing of the aircraft which also contains the external fuel tank. The gasket design of the invention includes a feature which provides effective sealing upon initial compression of the gasket during installation of the panel, and during flight when the external wing surfaces are subjected to a variety of dynamic loading forces due to variations in air pressure. As described in more detail herein, this feature permits the expansion of the gasket without rupturing or damaging the gasket, and thereby results in increased service life for the gasket. Other features useful for the practice of the invention are also described herein.

As used herein the term "aircraft" is intended to designate both commercial and military aircraft, jet and prop aircraft, including both large commercial and smaller private aircraft.

Also as used herein, the term "horizontal", as used with reference to the dimensions of the gasket, is intended to denote the plane in the x-axis and y-axis (commonly the length and width) of the gasket. The "thickness" of the gasket denotes the part of the gasket extending upwardly along the z-axis, which extends vertically from the plane of the x-axis and y-axis.

The term "grommet" is intended to denote a ring designed as a collar fitted on the innermost section of the annular gasket of the invention. The grommet can be a molded plastic or metal part. The function of the grommet is to effectively terminate the end section of the mesh facing the inner annular void, reinforcing this section and preventing premature failure of the gasket.

In particular, the gasket of the invention is intended to be installed between adjacent aircraft surfaces, and in particular between the fuel tank opening and the fuel tank access panel. The gasket is intended for sealing, to prevent leakage of the fuel from the fuel tank, to prevent the entry of external fluid into the gasket, and to protect the fuel tank from static electrical charges.

Typically, the gasket is shaped or prepared as an annular sheet with an open core section. The annular sheet can be cut from a larger sheet, for instance, or prepared as an annular component. Preferably, the gasket includes a grommet affixed to the innermost section of the gasket, i.e. the section of the gasket bordering on the inner void space. The grommet, which can be formed from a metal or plastic, encapsulates the inner section of the gasket, thereby terminating the gasket at the annular space. The grommet replaces small pieces of secondary wire mesh which had previously been mechanically inserted at the gasket interface. The secondary wire mesh pieces can create a mechanical standoff or stress riser which could lead to premature gasket failure. However, the use of a grommet to encapsulate the end section of the elastomer permits a more uniform compression around the circumference of the gasket.

The overall shape of the gasket is dictated by the shape of the fuel tank opening and access panel, and will typically be oval, round, square or rectangular. The gasket will also typically include holes for the attachment bolts or screws which secure the access panel to the fuel tank opening. When the gasket is tightened in place, the conductive mesh embedded in the elastomer contacts the adjacent aircraft surfaces thereby establishing an electrical bridge between the surfaces, thereby protecting the surfaces from EMI radiation and electrical discharges.

The gasket of the invention includes a zone or region of diminished thickness which allows for expansion of the gasket as a result of dynamic loading on the wing in flight due to changes in air pressure. In addition, adjacent to the zone of diminished thickness, the gasket also includes a zone of increased thickness to provide sealing for the interior sections of the gasket. This prevents the contamination and failure of the gasket as a result of dynamic forces acting on the gasket during flight. Contamination can result from moisture and other environmental fluids entering the seal area when the gasket is under stress.

The elastomeric material which can be used to fabricate the gasket of the invention can include, in general, both natural and synthetic rubbers, such as, for example, polyethylene, polypropylene, polypropylene-EPDM blends, butadiene, styrene-butadiene, nitrile rubber, chlorosulfonate, neoprene, urethane, polytetrafluoroethylene, polysulfide, silicone, or a copolymer, blend or combination of any of the foregoing polymers. Preferably, the elastomeric material is a fluorosilicone polymer reinforced with fibers, and particularly Kevlar fibers. The fibers provide increased toughness, tensile strength, and a high modulus of elasticity to the elastomeric sheet.

A conductive mesh is embedded in the gasket during the gasket fabrication process. This can be accomplished using known techniques, for instance, by incorporating the mesh in a mold cavity prior to injection of the elastomeric resin in liquid form, and subsequently curing the elastomer to form the gasket material. This material can be in the form of a sheet, which can then be cut into the appropriate annular shape required for the particular gasket. Alternatively, the gasket can be formed in a mold cavity having the desired annular shape.

The conductive mesh material of the gasket can be, for example, an expanded metal mesh or a metal wire screen or a metal-plated fabric sheet. Typically, the mesh sheet may be formed from metal or metal alloy wires or fibers, graphite or carbon fibers, or metallized or metal-coated or metal plated non-conductive woven or non- woven fabric, such as nylon fabric or nylon fibers. In general, the surface resistivity of the mesh sheet is less than about 0.1 Ω/sq.

As used herein, the term "mesh" includes fabrics, cloths, webs, mats, screens, meshes and the like, which may be open, such as in the case of a screen, or closed, such as in the case of a fabric.

The mesh can be inherently conductive if formed from a metal or metal alloy, graphite, carbon, etc., as wires, monofilaments, yarns, bundles, or other fibers or materials which are inherently conductive. Alternatively, the mesh can be non-conductive and rendered electrically-conductive by means of an applied coating, plating, sputtering, or other treatment of the electrically conductive material. Representative of the inherently electrically conductive materials include metals, such as copper, nickel, silver, aluminum, steel, tin and bronze, alloys thereof, such as Monel nickel-copper alloys, non-metals, such as carbon, graphite, and inherently conductive polymers, and plated or clad wires or other fibers such as one or more of copper, nickel, silver, aluminum, steel, tin, bronze, or an alloy thereof, e.g. silver-plated copper, nickel-clad copper, Ferrex^{®} (Parker Chomerics, Woburn, MA.), tin- plated copper-clad steel, tin-clad copper, and tin-plated phosphor bronze. Representative non-conductive fibers include cotton, wool, silk, cellulose, polyester, polyamide, nylon, and polyimide monofilaments or yarns which are plated, clad or otherwise coated with an electrically-conductive material which may be a metal mesh such as copper, nickel, silver, aluminum, tin, or an alloy or combination thereof, or a non-metal such as carbon, graphite, or a conductive polymer. The plating, cladding or other coating may be applied to individual fiber strands or to the surface of the fabric after weaving, knitting or other fabrication. Combinations of one or more of the foregoing conductive fibers and/or one or more of the foregoing coated non-conductive fibers may also be employed.

Preferably, the conductive mesh of the invention is formed from a metal wire, such as aluminum wire, and most preferably from triple stranded metal wire, i.e. metal wire in which three strands of wire are combined into a single strand. It has been found that a metallic mesh formed from triple stranded wire is superior to single stranded wire mesh which may not be robust enough to withstand high stress environments, and can therefore fail prematurely. The triple stranded wire creates a stronger poly-filament wire mesh. In addition, triple stranded wire reduces the relative movement between the strands typically induced by vibration, thereby reducing gasket abrasion and prolonging gasket life.

The various embodiments of the invention will now be more clearly described by reference to the drawings, which are illustrative only and not intended to be limiting in any way.

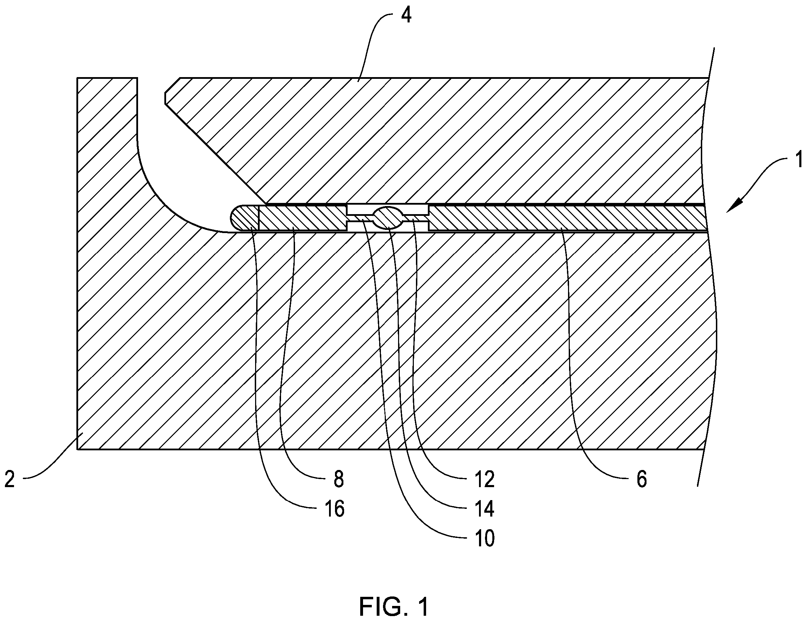

FIG. 1 illustrates one embodiment of the EMI shielding gasket of the invention. As shown in FIG. 1, gasket 1 is positioned generally between aircraft fuel tank access port 2 and fuel tank access door 4. Gasket 1, shown in the uncompressed state, is divided into several regions or zones. These include inner region 6, outer region 8, and a central region positioned there between. The central region includes two peripheral regions, outer peripheral region 10 and inner peripheral region 12, both adjoining intermediate region 14. As shown, peripheral regions 10 and 12 are thinner than adjacent regions 8 and 6. However, intermediate region 14 is thicker than the adjoining peripheral regions 12 and 14. This configuration allows the gasket to be compressed without compromising its structural integrity. The intermediate region 14 is shown in the shape of a bulb or as a 3-dimensional annular rod having a cross-section as shown. Also depicted in FIG. 1 is an optional rubberized tip element formed at the end of outer region 8. The peripheral regions 10 and 12 are thinner than the remainder of the gasket, and this allows expansion of the gasket into this space, thereby preventing gasket failure.

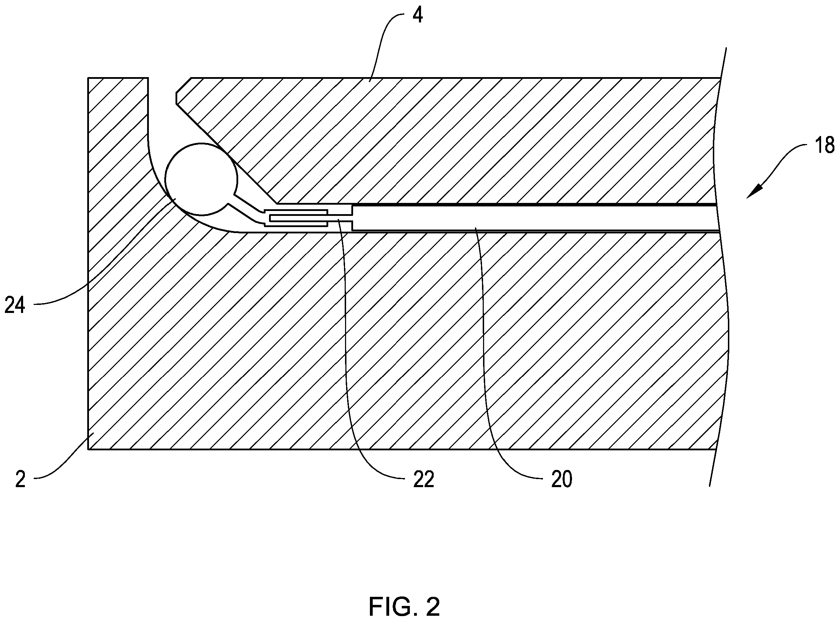

FIG. 2 illustrates another embodiment of the EMI shielding gasket of the invention. Gasket 18, positioned between aircraft fuel tank access port 2 and fuel tank access door 4, is shown in the uncompressed state. Gasket 18 is divided into two regions or zones. These include inner region 20 and outer region 22. Outer region 22 has a thickness which is less than the thickness of inner region 20. Affixed to the end portion of outer region 22 is a tip element 24 having a greater thickness than either inner region 20 or outer region 22. Tip element 24 is fabricated from a rubberized material, and can be in the shape of a bulb or aqs a cross-section of a 3 dimensional annular rod. As gasket 18 is compressed, rubberized tip element 24 compresses and seals the gasket from outside fluids, and also prevents leakage of fuel from the fuel tank.

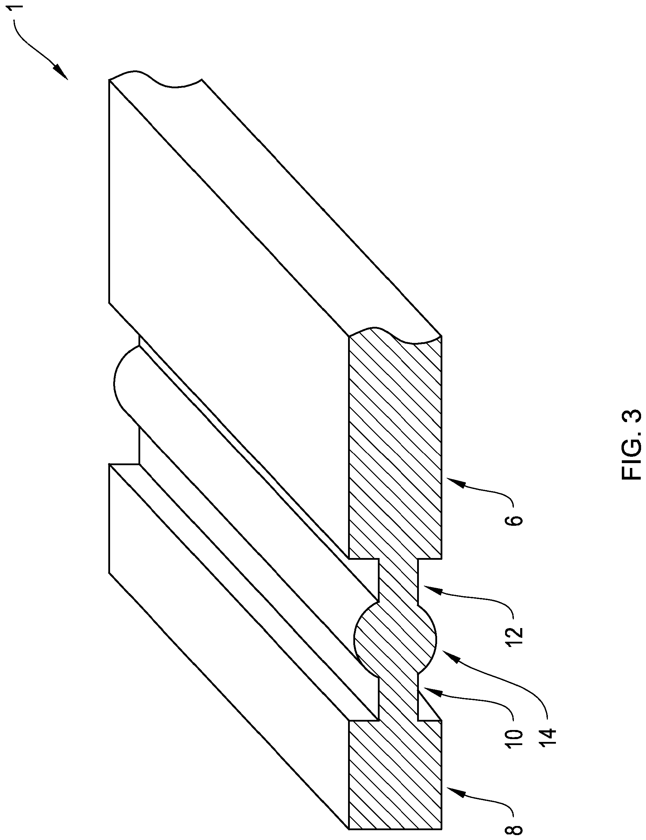

FIG. 3 is a perspective view of gasket 1 depicted in FIG. 1. FIG. 3 illustrates the different regions or zones of gasket 1, including inner region 6, outer region 8, outer peripheral region 10, inner peripheral region 12, and intermediate region 14. Intermediate region 14 is depicted in the shape of an annular rod, but one skilled in the art will readily appreciate that a variety of shapes are possible.

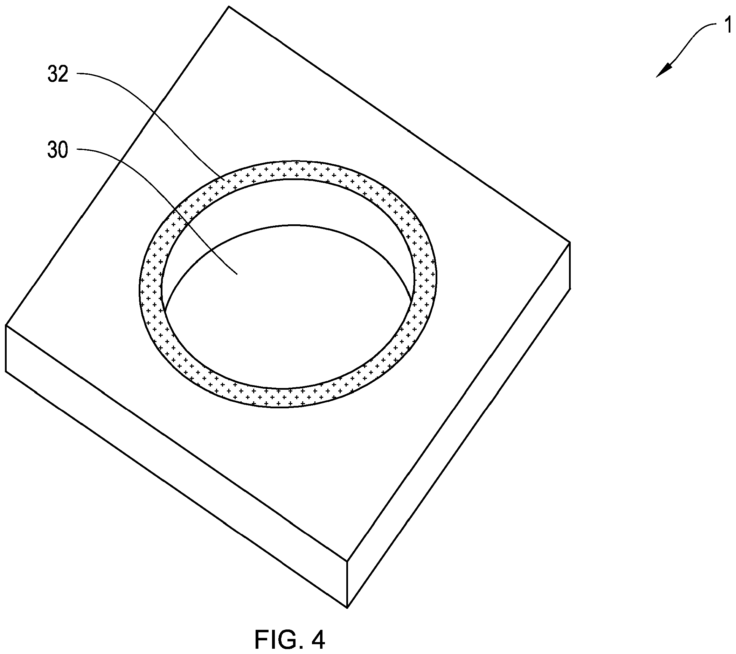

FIG. 4 is a perspective view of the inner region or inner end portion of annular gasket 1 depicting a grommet 32 sealing the gasket around opening 30. The grommet is preferably a molded plastic element positioned to seal or encapsulate the end section of the gasket, i.e. the section of the gasket surrounding interior opening 30.

The gaskets of the invention can be used in a variety of applications and under a variety of conditions. Preferably, the gaskets of the invention are used for sealing fuel tank access doors and panels to fuel tank access ports commonly used in wing-mounted fuel tanks for military and civilian aircraft.

As it is anticipated that certain changes may be made in the present invention without departing from its scope as defined by the appended claims, it is intended that all matter contained in the foregoing description shall be interpreted as illustrative and not in a limiting sense.

## Claims

1. An elastomeric EMI shielding gasket (1) for sealing aircraft fuel tank access doors and panels to the fuel tank access port, the gasket (1) being annular in shape with a hollow core section, the gasket (1) being a unitary elastomeric structure having embedded therein an electrically conductive mesh for establishing electrical conductivity between adjacent metallic surfaces, wherein the gasket (1) further comprises, as contiguous regions, an inner region (6), a central region, and an outer region (8), the inner and outer regions (6; 8) having the same thickness, the central region further comprising an intermediate zone (14) bounded by two peripheral zones (10; 12), the peripheral zones (10; 12) having a thickness less than the thickness of the inner and outer regions (6; 8), and in which the intermediate zone (14) has a thickness greater than the thickness of the peripheral zones (10; 12) and equal to the thickness of the inner and outer regions (6; 8).

2. The gasket (1) of claim 1 in which the intermediate zone (14) of the central section has a tubular shape.

3. The gasket (1) of claim 1 further comprising a rubberized tip (16) affixed to the end portion of the outer region (8) of the gasket (1).

4. The gasket (1) of claim 3 in which the rubberized tip (16) has approximately the same thickness as the thickness of the outer region (8).

5. An elastomeric EMI shielding gasket (18) for sealing aircraft fuel tank access doors and panels to the fuel tank access port, the gasket (18) being annular in shape with a hollow core section, the gasket being a unitary elastomeric structure having embedded therein an electrically conductive mesh for establishing electrical conductivity between adjacent metallic surfaces, wherein the gasket further comprises, as contiguous regions, an inner region and an outer region, in which the outer region has a thickness less than the thickness of the inner region, and in which the outer region has affixed to the end thereof a rubberized tip having a thickness greater than the thickness of the inner or outer regions.

6. The gasket (1; 18) of claim 1 or claim 5 in which the electrically conductive mesh is a metallic mesh.

7. The gasket (1; 18) of claim 6 in which the metallic mesh is formed from triple strand wire.

8. The gasket (1; 18) of claim 1 or claim 5 in which the electrically conductive mesh is formed from conductive metal fibers or plastic fibers coated with a conductive material.

9. The gasket (1; 18) of claim 1 or claim 5 in which the unitary elastomeric structure is a fluorosilicone elastomeric sheet.

10. The gasket (1; 18) of claim 9 in which the fluorosilicone is reinforced with Kevlar fibers.

11. The gasket (1; 18) of claim 1 or claim 5 in which a grommet (32) is affixed to the inner annular region of the gasket, forming a border between the gasket and the hollow core section, the grommet (32) encapsulating the innermost section of the gasket.

12. The gasket (1; 18) of claim 1 or claim 5 which is in the shape of an annular square or rectangle.

13. The gasket (1; 18) of claim 1 or claim 5 which is in the shape of an annular circle or oval.

## Patentansprüche

1. Elastomere EMI-Abschirmungsdichtung (1) zum Abdichten von Flugzeugtreibstofftankzugangspforten und Platten zur Treibstofftankzugangsöffnung, wobei die Dichtung (1) in der Form eines Rings mit einem hohlen Kernteilabschnitt ist, wobei die Dichtung (1) eine einheitliche Elastomerstruktur mit einem darin eingebetteten, elektrisch leitfähigen Gitter zum Herstellen von elektrischer Leitfähigkeit zwischen benachbarten metallischen Oberflächen ist, wobei die Dichtung (1) ferner einen inneren Bereich (6), einen zentralen Bereich und einen äußeren Bereich (8) als angrenzende Bereiche umfasst, wobei der innere und äußere Bereich (6; 8) dieselbe Stärke aufweisen, wobei der zentrale Bereich ferner eine zwischenliegende Zone (14) umfasst, die durch zwei umfängliche Zonen (10; 12) begrenzt ist, wobei die umfänglichen Zonen (10; 12) eine Stärke aufweisen, die geringer als die Stärke des inneren und äußeren Bereichs (6; 8) ist, und wobei die zwischenliegende Zone (14) eine Stärke aufweist, die größer als die Stärke der umfänglichen Zonen (10; 12) und gleich der Stärke des inneren und äußeren Bereichs (6; 8) ist.

2. Dichtung (1) nach Anspruch 1, wobei die zwischenliegende Zone (14) des zentralen Teilabschnitts eine Röhrenform aufweist.

3. Dichtung (1) nach Anspruch 1, ferner umfassend eine gummierte Spitze (16), die am Endabschnitt des äußeren Bereichs (8) der Dichtung (1) angebracht ist.

4. Dichtung (1) nach Anspruch 3, wobei die gummierte Spitze (16) ungefähr dieselbe Stärke wie die Stärke des äußeren Bereichs (8) aufweist.

5. Elastomere EMI-Abschirmungsdichtung (18) zum Abdichten von Flugzeugtreibstofftankzugangspforten und Platten zur Treibstofftankzugangsöffnung, wobei die Dichtung (18) in der Form eines Rings mit einem hohlen Kernteilabschnitt ist, wobei die Dichtung eine einheitliche Elastomerstruktur mit einem darin eingebetteten, elektrisch leitfähigen Gitter zum Herstellen von elektrischer Leitfähigkeit zwischen benachbarten metallischen Oberflächen ist, wobei die Dichtung ferner einen inneren Bereich und einen äußeren Bereich als angrenzende Bereiche umfasst, wobei der äußere Bereich eine Stärke aufweist, die geringer als die Stärke des inneren Bereichs ist, und wobei der äußere Bereich am Ende davon eine gummierte Spitze mit einer Stärke, die größer als die Stärke des inneren oder äußeren Bereichs ist, angebracht aufweist.

6. Dichtung (1; 18) nach Anspruch 1 oder 5, wobei das elektrisch leifähige Gitter ein Metallgitter ist.

7. Dichtung (1; 18) nach Anspruch 6, wobei das Metallgitter aus Dreifachstrangdraht ausgebildet ist.

8. Dichtung (1; 18) nach Anspruch 1 oder 5, wobei das elektrisch leitfähige Gitter aus leitfähigen Metallfasern oder Kunststofffasern, die mit einem leitfähigen Material beschichtet sind, ausgebildet ist.

9. Dichtung (1; 18) nach Anspruch 1 oder 5, wobei die einheitliche Elastomerstruktur eine Fluorsilikonelastomerbahn ist.

10. Dichtung (1; 18) nach Anspruch 9, wobei das Fluorsilikon mit Kevlar-Fasern verstärkt ist.

11. Dichtung (1; 18) nach Anspruch 1 oder 5, wobei eine Durchführungstülle (32) am inneren ringförmigen Bereich der Dichtung angebracht ist, die eine Abgrenzung zwischen der Dichtung und dem hohlen Kernteilabschnitt ausbildet, wobei die Durchführungstülle (32) den innersten Teilabschnitt der Dichtung einkapselt.

12. Dichtung (1; 18) nach Anspruch 1 oder 5, die in der Form eines ringförmigen Quadrats oder Rechtecks ist.

13. Dichtung (1; 18) nach Anspruch 1 oder 5, die in der Form eines ringförmigen Kreises oder Ovals ist.

## Revendications

1. Joint (1) de blindage EMI élastomère pour assurer l'étanchéité des portes et des panneaux d'accès au réservoir à carburant d'aéronef par rapport à l'orifice d'accès au réservoir à carburant, le joint (1) ayant une forme annulaire avec une section de noyau creux, le joint (1) étant une structure élastomère unitaire dans laquelle est incorporé un treillis électroconducteur pour établir une conductivité électrique entre des surfaces métalliques adjacentes, dans lequel le joint (1) comprend en outre, en tant que régions contiguës, une région interne (6), une région centrale et une région externe (8), les régions interne et externe (6 ; 8) ayant la même épaisseur, la région centrale comprenant en outre une zone intermédiaire (14) délimitée par deux zones périphériques (10; 12), les zones périphériques (10 ; 12) ayant une épaisseur inférieure à l'épaisseur des régions interne et externe (6 ; 8), et dans lequel la zone intermédiaire (14) a une épaisseur supérieure à l'épaisseur des zones périphériques (10 ; 12) et égale à l'épaisseur des régions interne et externe (6 ; 8).

2. Joint (1) de la revendication 1, dans lequel la zone intermédiaire (14) de la section centrale a une forme tubulaire.

3. Joint (1) de la revendication 1, comprenant en outre une pointe caoutchoutée (16) fixée à la partie d'extrémité de la région externe (8) du joint (1).

4. Joint (1) de la revendication 3, dans lequel la pointe caoutchoutée (16) a approximativement la même épaisseur que l'épaisseur de la région externe (8).

5. Joint (18) de blindage EMI élastomère pour assurer l'étanchéité des portes et des panneaux d'accès au réservoir à carburant d'aéronef par rapport à l'orifice d'accès au réservoir à carburant, le joint (18) ayant une forme annulaire avec une section de noyau creux, le joint étant une structure élastomère unitaire dans laquelle est incorporé un treillis électroconducteur pour établir une conductivité électrique entre des surfaces métalliques adjacentes, dans lequel le joint comprend en outre, en tant que régions contiguës, une région interne et une région externe, dans lequel la région externe a une épaisseur inférieure à l'épaisseur de la région interne, et dans lequel la région externe a une pointe caoutchoutée fixée à son extrémité ayant une épaisseur supérieure à l'épaisseur de la région interne ou externe.

6. Joint (1 ; 18) de la revendication 1 ou 5, dans lequel le treillis électroconducteur est un treillis métallique.

7. Joint (1 ; 18) de la revendication 6, dans lequel le treillis métallique est formé à partir de fil à triple torons.

8. Joint (1 ; 18) de la revendication 1 ou 5, dans lequel le treillis électroconducteur est formé à partir de fibres métalliques conductrices ou de fibres en plastique revêtues d'un matériau conducteur.

9. Joint (1 ; 18) de la revendication 1 ou 5, dans lequel la structure élastomère unitaire est une feuille élastomère en fluorosilicone.

10. Joint (1 ; 18) de la revendication 9, dans lequel le fluorosilicone est renforcé avec des fibres de Kevlar.

11. Joint (1 ; 18) de la revendication 1 ou 5, dans lequel un passe-fil (32) est fixé à la région annulaire interne du joint, formant une bordure entre le joint et la section de noyau creux, le passe-fil (32) encapsulant la section la plus interne du joint.

12. Joint (1 ; 18) de la revendication 1 ou 5, qui a la forme d'un carré ou d'un rectangle annulaire.

13. Joint (1 ; 18) de la revendication 1 ou 5, qui a la forme d'un cercle ou d'un ovale annulaire.
